# EUROPEAN PATENT APPLICATION

(11) **EP 1 703 601 A1**
(43) Date of publication of application: **20.09.2006**
(21) Application number: 06110833.8
(22) Date of filing: 08.03.2006
(51) Int. Cl.: H01S 3/067, H01S 3/0941, G02B 6/26, G02B 27/09, G02B 6/42

(54) **Fiber laser oscillator**

(30) Priority: 15.03.2005 JP 2005072880
(71) Applicant: JTEKT CORPORATION, Chuo-ku Osaka-shi Osaka 542-8502 (JP)
(72) Inventor: OTA, Hiromichi, Osaka-shi Osaka 542-8502 (JP); NIINO, Yasuo, Osaka-shi Osaka 542-8502 (JP); NAKANO, Tomomi, Osaka-shi Osaka 542-8502 (JP); KATOH, Yoshinobu, Osaka-shi Osaka 542-8502 (JP)
(74) Representative: TBK-Patent

(57) **Abstract**

A fiber laser oscillator 1 is provided with a pumping light source 30 for emitting pumping beams Lin; beam condensing means (light duct) 50 for condensing the pumping beams Lin emitted from the pumping light source 30; and a laser oscillation optical fiber 10 for receiving the pumping beams Lin condensed by the beam condensing means 50 to generate an output laser beam Lout. The beam condensing means 50 has an incident surface Min for making the pumping beams Lin from the pumping light source 30 incident thereon and an emission surface Mout for emitting the pumping beams Lin therefrom. The emission surface Mout is made smaller in area than the incident surface Min. Further, the area of the emission surface Mout is made to be the same as or smaller than that of one end surface of the laser oscillation optical fiber 10.

## Description

### INCORPORATION BY REFERENCE

This application is based on and claims priority under 35 U.S.C. 119 with respect to Japanese Application No. 2005-072880 filed on March 15, 2005, the entire content of which is incorporated herein by reference.

### BACKGROUND OF THE INVENTION

### Field of the Invention:

The present invention relates to a fiber laser oscillator wherein a laser oscillation optical fiber with a core member inside including a laser pumping (excitation) substance generates and amplitudes a laser beam within the core member upon the incidence of a pumping (excitation) beam thereto.

### Discussion of the Related Art:

Heretofore, there have been proposed various fiber laser oscillators each capable of efficiently obtaining a very high-quality laser beam by the use of a pumping beam which is relatively inferior in its beam quality.

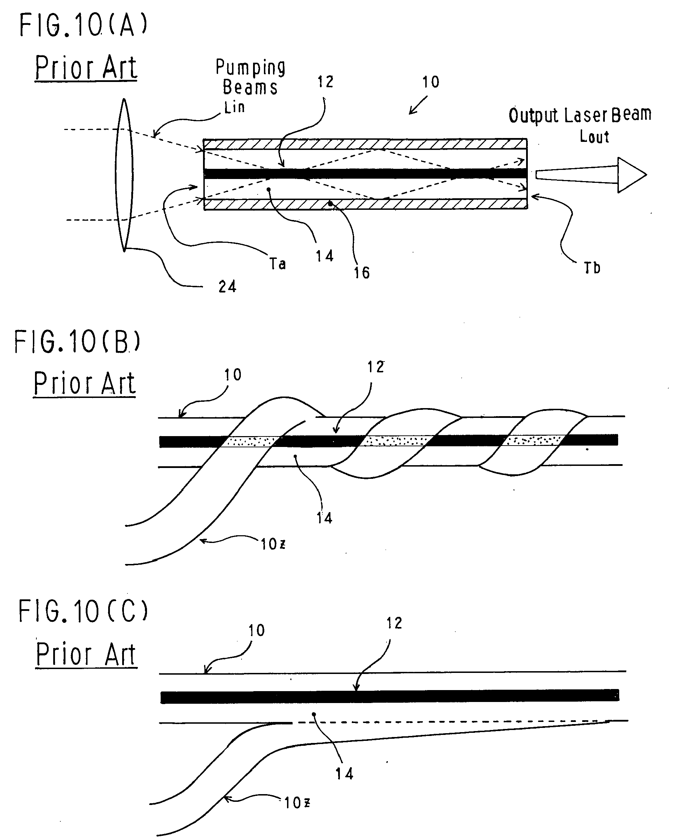

United States Patent No. 5,999,673 to Valentin et al. discloses a conventional laser oscillation optical fiber 10 shown in Figure 10(A) which is designed for use in a prior art fiber laser oscillator or the like of the end pumping type. The prior art laser oscillation optical fiber 10 has a core member 12 (a fiber shape member of the diameter in a range of 2 to 12 µm into which a rare-earth metal (e.g., Nd, Er) or the like is doped and which enables a single mode laser beam to pass therethrough) at the center of its section. A first clad member 14 (a member for allowing the pumping beam Lin to pass therethrough) having a smaller refractive index than that of the core member 12 is provided around the core member 12 to confine an output leaser beam Lout within the core member 12. Further, a second clad member 16 having a smaller refractive index than that of the first clad member 14 is formed around the first clad member 14 to confine the pumping beam Lin within the first clad member 14.

Further, when the pumping beam Lin incident to the laser oscillation optical fiber 10 passes through the core member 12 (i.e., comes into collision with the core member 12), the rare-earth metal in the core member 12 is excited or pumped to generate the output laser beam Lout, and the output laser beam of a single mode remains in the core member 12. Being small in diameter (in dependence on the diameter of the core member 12) as well as in the spread angle (in dependence on the wavelength of the output laser beam Lout, refractive indexes of the core member 12 and the first clad member 14 and the like), the output laser beam Lout is very high in beam quality (i.e., the beam quality of the output laser beam Lout can be expressed by the product of the radius of an emission beam with the half angle of the spread angle of the emission beam and thus, is enhanced as the product becomes smaller). However, the cross-section at the end surface of the laser oscillation optical fiber 10 is small, which causes the pumping beam Lin to be small in power, so that it has been desired to make the pumping beam Lin high in power.

Also in the aforementioned prior art, in order to lead a greater number of pumping beams to the laser oscillation optical fiber 10, there have been proposed a method of fiber-jointing an pumping beam leading optical fiber 10z around the laser oscillation optical fiber 10 by winding, as shown in Figure 10(B), and another method of fiber-jointing the lateral surface of an pumping beam leading optical fiber 10z onto the laser oscillation optical fiber 10 gradually in the lengthwise direction of the same, as shown in Figure 10(C). In the prior art practicing the proposed methods, when the pumping beam Lin is incident to the pumping beam leading optical fiber 10z, the incident pumping beam Lin is led from the fiber-joining portion into the laser oscillation optical fiber 10.

In the conventional laser oscillation optical fiber 10, the diameter of the core member 12 is set in a range of about 2 through 12 µm (micron meters) for a higher quality laser beam (i.e., as mentioned earlier, the beam quality of the output laser beam Lout can be expressed by the product of the radius of an emission beam with the half angle of the spread angle of the emission beam and thus, is enhanced as the product becomes smaller). The diameter of the first clad member 14 is set in a range of about several 100 through several 1000 µm.

The fiber laser oscillator of the end pumping type exemplified in Figure 10(A) is small in the area of the end surface of the first clad member 14 for making the pumping beam Lin incident thereon. Further, the ratio of the cross-section area of the core member 12 to that of the first clad member 14 is very small, wherein the probability for the pumping beam Lin to pass through the core member 12 is not so high, and the oscillation efficiency can not be high. While the enlargement in the diameter of the first clad member 14 enables a greater number of the pumping beams Lin to be incident thereto, the probability for the pumping beams Lin to pass through the core member 12 decreases to lower the oscillation efficiency. Where the diameter of the core member 12 is enlarged for higher oscillation efficiency, on the other hand, the beam quality is degraded. Since the pumping beam Lin is relatively low in the beam quality, it is very difficult to make the pumping beam Lin incident toward the target for collision with the core member 12.

For the aforementioned reasons, in the fiber laser oscillator of the end pumping type exemplified in Figure 10(A), it is very difficult to generate the output laser beam Lout of a relatively high power.

In the prior art (Figures 10(B) and 10(C)) described in the aforementioned United States Patent, the pumping beam leading optical fiber 10z is restricted to enlarge the diameter, and thus, a large restriction is given to the quantity of the pumping beam Lin which the pumping beam leading optical fiber 10z makes incident thereto. Therefore, in order to obtain a high-power output laser beam Lout, it is necessary to fiber-join the pumping beam leading optical fibers 10z of quite many numbers (e.g., several hundreds through several thousands or so), which undesirably results in making the fiber laser oscillator difficult to manufacture as well as in making the system enlarged in dimension.

Where the pumping beam leading optical fibers 10z of so many numbers are used, due to many numbers of parts (the number of the pumping beam leading optical fibers 10z in this case), the probability of errors to occur becomes relatively high (i.e., it is difficult to process all the pumping beam leading optical fibers 10z to have the quite same state of the fiber-joint and to make the position adjustment of each pumping beam leading optical fiber 10z with each pumping beam Lin, so that variations (errors) occur usually), and it will therefore be likely that each pumping beam Lin cannot be made incident efficiently to the laser oscillation optical fiber 10.

### SUMMARY OF THE INVENTION

It is therefore a primary object of the present invention to provide a fiber laser oscillator which is capable of making a greater quantity of pumping beam incident thereto with a simpler construction and which is smaller in dimension and higher in output power.

Briefly, in one aspect of the present invention, there is provided a fiber laser oscillator which comprises a pumping light source for emitting a pumping beam; beam condensing means for condensing the pumping beam emitted from the pumping light source; and a laser oscillation optical fiber for receiving the pumping beam condensed by the beam condensing means to generate an output laser beam. The beam condensing means has an incident surface for making the pumping beam from the pumping light source incident thereon and an emission surface for emitting the pumping beam therefrom, wherein the emission surface is made smaller in area than the incident surface. Further, the area of the emission surface is made to be the same as or smaller than that of one end surface of the laser oscillation optical fiber.

With this configuration, it is possible to make the pumping beam incident on the incident surface of the beam condensing means which surface is larger in area than the end surface of the laser oscillation optical fiber, so that a greater quantity of the pumping beam can be incident to the laser oscillation optical fiber. In a preferred form, the beam condensing means may be constituted by a light duct taking an approximately conical shape with incident and emission surfaces at axial ends thereof.

In another or second aspect of the present invention, there is provided a fiber laser oscillator which comprises a laser oscillation optical fiber formed to be a rod-like shape and composed a rod-like core member extending in a lengthwise direction and a clad member smaller in refractive index than the core member and covering the external surface of the core member, the core member including a laser activating substance; an pumping light source provided with a plurality of beam emission parts for emitting pumping beams; and a light duct having an incident surface for making the pumping beams from the plurality of beam emission parts incident thereon and an emission surface smaller in area than the incident surface and capable of condensing the pumping beams incident from the incident surface onto the emission surface. The emission surface of the light duct is made to be the same shape as or smaller than one end surface of the laser oscillation optical fiber and is joined to said one end surface. The shape of the light duct is determined by adjusting the dimensions of the incident and emission surfaces of the light duct and the distance between the incident and emission surfaces of the light duct so that when the pumping beams incident on the incident surface of the light duct and reaching the emission surface of the light duct are made incident on said one end surface of the laser oscillation optical fiber joined to the emission surface of the light duct, the incident angle of the pumping beams on the incident surface becomes less than or equal to an NA value representing the numerical aperture of the laser oscillation optical fiber. Further, the pumping light source is placed on the side of the incident surface of the light duct so that the pumping beams from the pumping light source are incident on the incident surface and so that the light duct condenses the incident pumping beams and makes the condensed pumping beams from the emission surface incident on said one end surface of the laser oscillation optical fiber.

With the configuration in the second aspect of the present invention, the shape of the light duct is determined to a more appropriate shape to make the pumping beams incident to the laser oscillation optical fiber with quite few beams to come out. Therefore, a greater number of the pumping beams can be incident to the laser oscillation optical fiber in a simplified construction, and it can be realized to provide a fiber laser oscillator which is smaller in dimension and higher in output power.

### BRIEF DESCRIPTION OF THE ACCOMPANYING DRAWINGS

The foregoing and other objects and many of the attendant advantages of the present invention may readily be appreciated as the same becomes better understood by reference to the preferred embodiments of the present invention when considered in connection with the accompanying drawings, wherein like reference numerals designate the same or corresponding parts throughout several views, and in which:
Figure 1 is a schematic view showing the general construction of a fiber laser oscillator 1 according to an example of the present invention;
Figures 2 (A) through 2(E) are explanatory views for explaining a pumping light source 30;
Figures 3(A) through 3(D) are explanatory views for explaining the shape (dimensional ratio and the like) of a light duct 50;
Figure 4 is an explanatory view showing a fiber laser oscillator 1 in a first embodiment;
Figure 5 is an explanatory view showing a fiber laser oscillator 1 in a second embodiment;
Figure 6 is an explanatory view showing a fiber laser oscillator 1 in a third embodiment;
Figure 7 is an explanatory view showing a fiber laser oscillator 1 in a fourth embodiment;
Figure 8 is an explanatory view showing a fiber laser oscillator 1 in a fifth embodiment;
Figure 9 is an explanatory view showing a fiber laser oscillator 1 in a sixth embodiment; and
Figures 10(A) through 10(C) are explanatory views showing examples of prior art fiber laser oscillators.

### DETAILED DESCRIPTION OF THE PREFERRED EMBODIMENTS

The embodiments of the present invention will be described in detail with reference to the accompanying drawings.

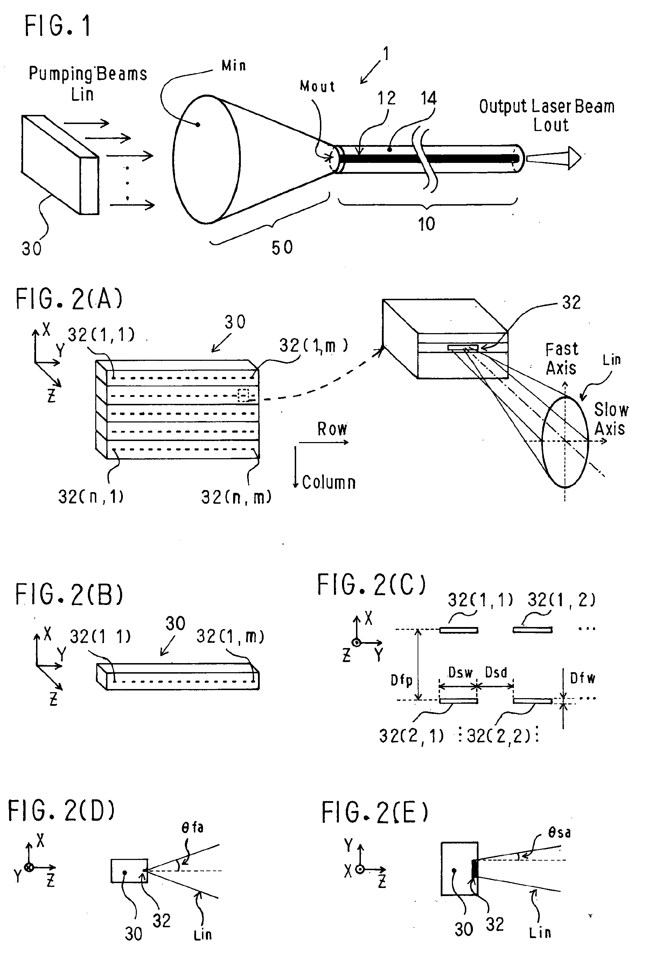

### (General Construction of Fiber Laser Oscillator and Details of Components: Figures 1 through 3)

Figure 1 is a schematic view showing the general construction of a fiber laser oscillator 1 according to an example of the present invention.

A laser oscillation optical fiber 10 includes a rod-like core member 12 which extends in a lengthwise direction with a laser activating substance included therein. The fiber 10 takes a rod-like shape in which a clad member 14 having a smaller refractive index than the core member 12 covers the external surface of the core member 12.

A pumping light source 30 is provided with a plurality of beam emission parts 32 (refer to Figures 2(A) to 2(E)) for emitting pumping beams.

An end surface of the laser oscillation optical fiber 10 is smaller than a beam emission surface of the pumping light source 30, and thus, with this construction, all of the plural pumping beams Lin emitted from the pumping light source 30 cannot be incident on the end surface of the laser oscillation optical fiber 10. Therefore, a light duct 50 whose incident surface Min for the pumping beams Lin is larger than an emission surface Mout is used to condense the pumping beams Lin to the emission surface Mout. The shape of the emission surface Mout of the light duct 50 is made to be the same shape as or to be smaller shape than the end surface of the laser oscillation optical fiber 10, and the emission surface Mout is joined to one end surface of the laser oscillation optical fiber 10.

As described above, the fiber laser oscillator 1 is provided with the pumping right source 30 for emitting the plurality of pumping beams Lin towards the incident surface Min of beam condensing means (the light duct 50 in this embodiment), the beam condensing means (the light duct 50 in this embodiment) for condensing the pumping beams Lin emitted from the pumping light source 30 to lead the condensed pumping beams Lin to one end surface of the laser oscillation optical fiber 10, and the laser oscillation optical fiber 10 for generating an output laser beam Lout from the pumping beams Lin led thereto.

In the beam condensing means (the light duct 50 in this embodiment), the emission surface Mout for emitting the pumping beams Lin incident thereto is formed to be smaller in area than the incident surface Min for receiving the pumping beams Lin thereto. The area of the emission surface Mout is formed to be the same as or smaller than the area of one end surface of the laser oscillation optical fiber 10, and the emission surface Mout is joined to the one end surface.

It is to be noted that a single number of the pumping beam Lin may be used instead of the plurality of pumping beams Lin. Even where the pumping beam Lin is singular in number, it can be condensed by the right duct 50 to be led to the laser oscillation optical fiber 10 whose diameter is smaller. It is also to be noted that the emission surface Mout and the one end surface of the laser oscillation optical fiber 10 are not necessarily required to be joined to each other and rather, may be placed to be close to each other.

The pumping light source 30 will be described with reference to Figures 2(A) through 2(E).

In the present embodiment, semiconductor lasers are used as the pumping beams Lin. As shown in Figure 2(A), each semiconductor laser (pumping beam Lin) travels as spreading in a fast axis direction (X-axis direction) as well as in a slow axis direction (Y-axis direction), wherein the half angle of the spread angle in the fast axis direction is about 40 degrees (designated as θfa in Figure 2(D)) while the half angle of the spread angle in the slow axis direction is about 3.5 degrees (designated as θsa in Figure 2(E)). In making the pumping beams Lin incident to an optical fiber, a collimation lens is generally used to condense the pumping beams Lin in the fast axis direction and to make them parallel in the fast axis direction. On the other hand, since the spread angle in the slow axis direction is small, the pumping beams Lin are made incident to the optical fiber without being subjected to beam condensation or the like.

Further, in a conventional laser array, the width (Dsw in Figure 2(C)) of each emission part 32 in the slow axis direction is about 0.2 mm (millimeters), the distance (Dsd in Figure 2(C)) between adjoining emission parts 32 in the slow axis direction is about 0.2 mm, the distance (Dfp in Figure 2(C)) between adjoining emission parts 32 in the fast axis direction is about 2 mm, and the width (Dfw in Figure 2(C)) of each emission part 32 in the fast axis direction is about 0.002 mm.

Further, for the semiconductor lasers, it is conventional to use a stack type laser diode (Figure 2(A)) with the emission parts 32 arranged in two-dimensionally, an array type laser diode (Figure 2(B)) with the emission parts arranged in line in the slow axis direction, or the like.

The embodiments described hereunder will be described as those utilizing the stack type laser diode shown in Figure 2(A) as the pumping light source 30.

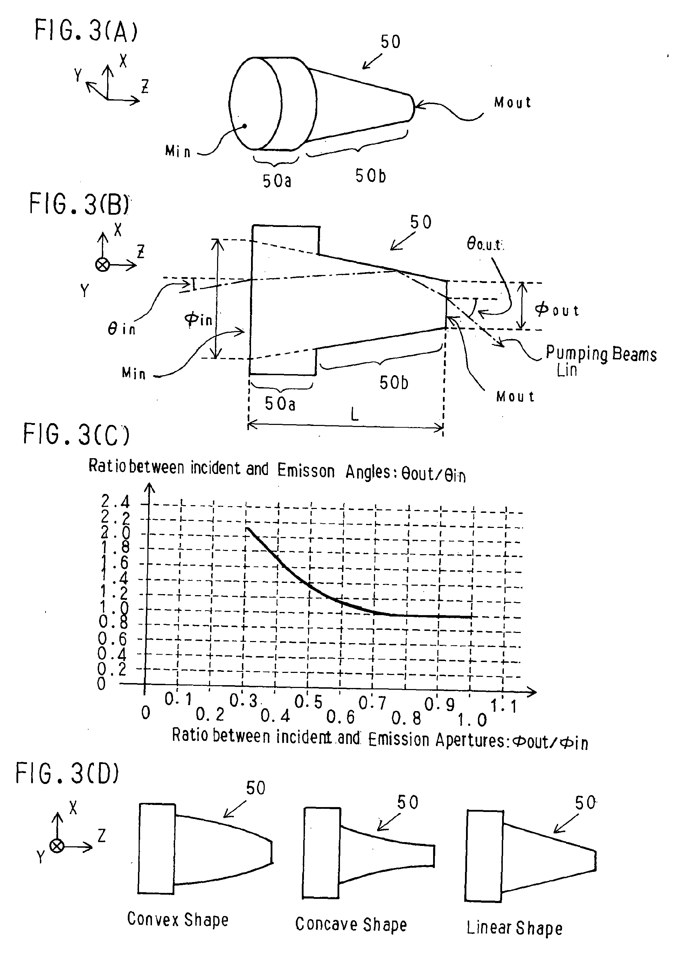

Next, the light duct 50 will be described with reference to Figures 3(A) through 3(D).

As exemplified in Figure 3(A), the light duct 50 described in the present embodiment takes an approximately conical shape having an upper surface (emission surface Mout) and a lower surface (incident surface Min) and is made of, e.g., a material (quartz glass or the like) having the same refractive index as the clad member 14 and allowing the pumping beams Lin to pass therethrough.

The light duct 50 exemplified in Figures 3(A) and 3(B) is formed to take a cylindrical shape at an incident neighborhood section 50a including the incident surface Min and an approximately conical shape at an emission neighborhood section 50b extending forward from the incident neighborhood section 50a. The reason why the incident neighborhood section 50a takes an approximately cylindrical shape is because a surface which does not reflect the pumping beams Lin is necessary as a portion at which a housing (not shown) for the fiber laser oscillator 1 supports the light duct 50. That is, where the surface which reflects the pumping beams Lin is supported, the boundary of a supported portion (the boundary between the light duct 50 and a support member therefor) differs in refractive index from the remaining portion of the light duct 50 not to effect the total reflection of the pumping beams Lin. The provision of the cylindrical portion is to prevent the occurrence of this deficiency.

Accordingly, it is preferable to provide the support portion at a portion adjacent to the incident surface Min where the reflection of the pumping beams Lin hardly takes place. Alternatively, where the external surface of the light duct 50 is covered with a second clad member smaller in refractive index than the light duct 50, it is possible to make the light duct 50 approximately conical as a whole (because it can be held at the second clad member).

Further, in order that the light duct 50 can be held in the vertical direction (X-axis direction) or the left-right direction (Y-axis direction), it is preferable to provide the light duct 50 with surfaces parallel in the vertical direction or the left-right direction. The external surface of the cylindrical shape defines the parallel surfaces for that purpose.

The function required for the light duct 50 is to condense the pumping beams (typically indicated by one-dot-chain line in Figure 3(B)) incident to the incident surface Min to the emission surface Mout while totally reflecting the pumping beams and to make the pumping beams Lin from the emission surface Mout incident on an end surface of the laser oscillation optical fiber 10.

End surfaces of the laser oscillation optical fiber 10 have a numerical aperture inherent thereto (which is called "NA value" and is expressed by a sine (sin θ) of an incident angle (θ) to, the end surface). It is required to determine the shape of the light duct 50 so that the sine (sin θout) of the spread angle (θout in Figure 3(B)) of the pumping beams Lin which are emitted from the emission surface Mout of the light duct 50 becomes equal to or less than the numerical aperture.

The shape of the light duct 50 to be determined in this case includes dimensions of the incident surface Min and the emission surface Mout and the length of the light duct 50.

Next, an example will be described regarding a method of determining the dimensions of the incident surface Min and the emission surface Mout. In an example taken in this embodiment, the numeral aperture of the laser oscillation optical fiber 10 was set to 0.4, the length L of the light duct 50 was set to 10mm, the spread angle (θin) of the pumping beams Lin incident on the incident surface Min was set to 15 degrees, and the number of the emission parts 32 for the pumping beams Lin was set to 19. Then, in this example, while varying the ratio (incident-emission aperture ratio: Φout/Φin) between the aperture (Φin) of the incident surface Min and the aperture (Φout) of the emission surface Mout, a simulation was carried out for the relation of the ratio (incident-emission spread angle ratio: θout/θin) between the spread angle (θin) of the pumping beams Lin incident on the incident surface Min and the spread angle (θout) of the pumping beams Lin emitted from the emission surface Mout. Figure 3(C) is a graph showing the result of the simulation.

As shown in Figure 3(B), the aperture Φin of the incident surface Min is the aperture on an extension from the conical shape at the emission neighborhood section 50b and is not the aperture of the incident neighborhood section 50a.

As understood from Figure 3(C), where the incident-emission aperture ratio (Φout/Φin) is set to 1.0 for example (i.e., where the incident surface Min and the emission surface Mout are the same in the aperture), the incident-emission spread angle ratio (θout/θin) is 1.0, whereby where the spread angle (θin) of the pumping beams Lin incident on the incident surface Min is 15 degrees, the spread angle (θout) of the pumping beams Lim emitted from the emission surface Mout becomes 15 degrees.

Here, a tolerable limit of the spread angle (sin⁻¹0.4=23.57 degrees) is obtained from the numeral aperture 0.4, and a selection is made for an incident-emission aperture ratio which becomes less than or equal to an incident-emission spread angle ratio (in this case, 23.57 / 15 = 1.7) which is in turn obtained from the tolerable limit of the spread angle. For example, errors are taken into account, so that the smallest value 0.5 is selected from the incident-emission aperture ratios satisfying that the incident-emission spread angle ratio is less than or equal to 1.4 (in this case, the incident surface Min becomes large as the ratio becomes smaller). That is, in this case, it is possible to select the aperture Φin of the incident surface Min as twice as larger as the aperture Φout of the emission surface Mout. Consequently, the area of the incident surface Min becomes four times as large as the area of the emission surface Mout, so that the incident surface Min can make a greater number of the pumping beams Lin incident thereon.

The result of the foregoing simulation is the result which was obtained from the example wherein the external surface of the light duct 50 was linear (refer to Figure 3(D)) and wherein the length of the light duct 50 was 10 mm. However, various simulations may be carried out while variously altering the length and the shape of the light duct 50, and a suitable incident-emission aperture ratio may be selected from the result of such various simulations. It is to be noted that besides the linear shape, a convex shape, a concave shape or the like shown in Figure 3(D) can be taken as the shape of the external surface of the light duct 50, in which case operation expressions for the simulation can be altered in dependence on the shape selected.

The shape of the light duct 50 is determined as fully described hereinabove, and description will next be made regarding fiber laser oscillators in first through sixth embodiments using the light duct 50. In the following description, the light duct 50 of the linear shape is taken as example, while some of the embodiments use the light duct 50 whose shape is altered to some degree.

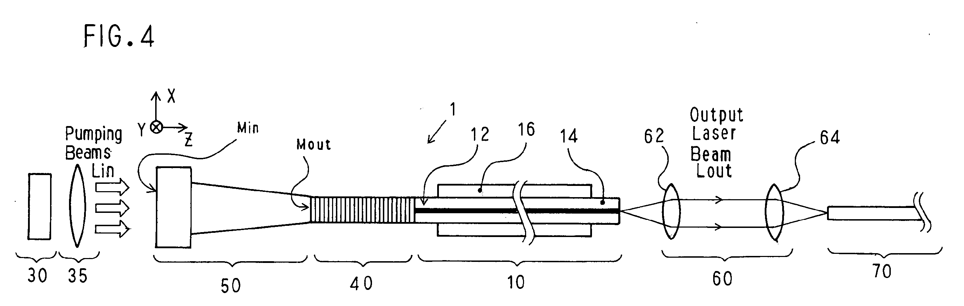

### (First Embodiment: Figure 4)

Figure 4 is an exterior view showing the entire construction of a fiber laser oscillator 1 in the first embodiment, wherein the laser oscillation optical fiber 10 only is shown as a sectional view taken along a plane including a core member 12 therein.

In the fiber laser oscillator 1 in the first embodiment, a light duct 50 whose shape is shown in Figures 3(A) and 3(B) is used as it is, and a feature resides in that a selective reflection member 40 for reflecting an output laser beam Lout and for allowing the pumping beams Lin to pass therethrough is provided between the right duct 50 and the laser oscillation optical fiber 10.

Because a stack type laser diode is used as a pumping light source 30 in the present embodiment, pumping beam condensing means 35 is used for making the spread angle of the pumping beams Lin small. As the pumping beam condensing means 35, various lenses such as a concave lens, a cylindrical lens, a lens unit composed by combining these plural lenses or the like can be used in dependence on the properties of the pumping light source 30 such as, e.g., the direction and dimension of the spread angle of the pumping beams Lin emitted from the pumping light source 30, the area for arrangement of the plural emission parts 32, and the like. The pumping light source 30 and the pumping beams condensing means 35 are common to the first through sixth embodiments.

In each of the first through sixth embodiments described hereunder, as the laser oscillation optical fiber 10, there is exemplified one in which the external surface of a clad member 14 is covered with a second clad member 16 which is smaller in refractive index than the clad member 14. However, the second clad member 16 may be omitted in a modified form.

The selective reflection member 40 takes an approximately cylindrical shape whose aperture is the same as or smaller than the aperture of the clad member 14 of the laser oscillation optical fiber 10. The selective reflection member 40 is joined at one end surface thereof to an end surface of the laser oscillation optical fiber 10 and is also joined at the other end surface thereof to the emission surface Mout of the light duct 50. For example, the selective reflection member 40 can be constituted by an optical fiber converter called "Fiber Bragg Grating" or the like for reflecting beams with the wavelength of the output laser beam Lout and for allowing beams of other wavelengths (including the wavelength of the pumping beams Lin) than the wavelength of the output laser beam Lout, to pass therethrough.

The plurality of pumping beams Lin emitted from the pumping light source 30 are condensed by the pumping beam condensing means 35 to be made incident on the incident surface Min of the light duct 50. The pumping beams Lin incident to the light duct 50 travel toward the emission surface Mout while being reflected within the light duct 50 and are made incident from the emission surface Mout of the light duct 50 on one end surface of the selective reflection member 40.

The selective reflection member 40 is selected to make beams of the same wavelength as that of the pumping beams Lin pass therethrough, and thus, the pumping beams Lin are made incident from the other end surface of the selective reflection member 40 on one end surface of the laser oscillation optical fiber 10 (i.e., on the end surface of the clad member 14 confining the pumping beams Lin therein).

The pumping beams Lin incident on the laser oscillation optical fiber 10 are confined within the clad member 14 and travel toward the other end surface while being reflected therein. When the pumping beams Lin come into collision with the core member 12, the output laser beam Lout is generated within the core member 12, and the output laser beam Lout performing the total reflection within the core member 12 remain within the core member 12. The output laser beam Lout includes an output laser beam Lout which travels toward the light duct 50 in the lengthwise direction of the core member 12 and another output laser beam Lout which travels in a direction opposite to the light duct 50. However, the output laser beam Lout which traveled towards the light duct 50 is reflected by the selective reflection member 40 upon reaching the end surface of the laser oscillation optical fiber 10 thereby to become the output laser beam Lout traveling in the direction opposite to the light duct 50.

The output laser beam Lout is output from the end surface (the end surface of the core member 12 in this case) on the side opposite to the light duct 50 of the laser oscillation optical fiber 10. The output laser beam Lout output outside the laser oscillation optical fiber 10 is condensed by output laser beam condensing means 60, and the condensed output laser beam Lout is made incident on one end surface of a conveyance optical fiber 70, from which the output laser beam Lout is taken out.

The output laser beam condensing means 60 is composed of, e.g., a collimation lens 62 for converting into a parallel beam the output laser beam Lout which is output from the laser oscillation optical fiber 10 to have a predetermined spread angle and a beam condensing lens 64 for condensing the output laser beam Lout converted into the parallel beam, on the end surface of the conveyance optical fiber 70. A single lens or a greater number of lenses may be used to compose the output laser beam condensing means 60. Of course, a suitable light duct may be composed at this place for use as the output laser beam condensing means 60.

The output laser beam Lout which is emitted from the other end surface of the conveyance optical fiber 70 can be used by various apparatus such as laser machining apparatus or the like using such laser beam.

Regarding the dimensions of the laser oscillation optical fiber 10, the aperture of the clad member 14 is about 1 mm (millimeters), the aperture of the core member 12 is about 0.1 mm, and the length of the core member 12 in the lengthwise direction is about 20 m (meters). Because the laser oscillation optical fiber 10 can be wound up around a circle of an allowable diameter, it is not meant that the linear distance of about 20 meters long is needed for the arrangement of the laser oscillation optical fiber 10. While performing the total refection within the clad member 14, the pumping beams Lin pump the core member 12 to oscillate the laser beams and is damped gradually, and therefore, the length in the lengthwise direction may be set to a distance which enables the pumping beams Lin to be damped almost completely.

Further, the aperture of the selective reflection member 40 is about 1 mm which is the same as that of the clad member 14, and the length of the selective reflection member 40 in the lengthwise direction is several centimeters or so.

Further, regarding the light duct 50, the aperture of the emission surface Mout is about 1 mm which is the same as that of the clad member 14, the aperture of the incident surface Min is about 2 mm, and the length in the lengthwise direction is about 10 mm (which is the same as that of the light duct exemplified in Figure 3(C)).

Further, the distance from the pumping light source 30 to the light duct 50 suffices to be several centimeters long or so, and the distance from the laser oscillation optical fiber 10 to the conveyance optical fiber 70 also suffices to be several centimeters long or so.

Accordingly, the fiber laser oscillator 1 is very small in dimension.

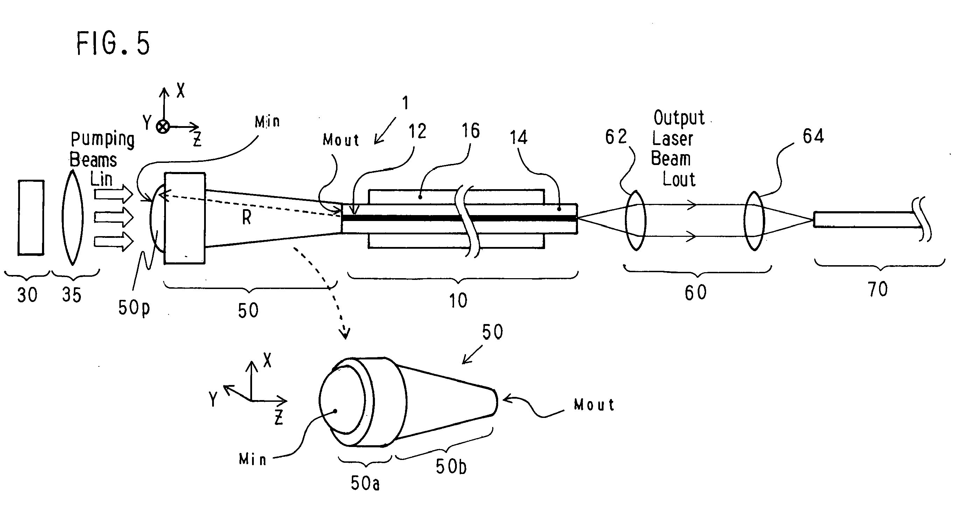

### (Second Embodiment: Figure 5)

Figure 5 is an exterior view showing the entire construction of a fiber laser oscillator 1 in the second embodiment, wherein a laser oscillation optical fiber 10 only is shown as a sectional view taken along a plane including a core member 12 therein.

Compared with that in the first embodiment, features of the fiber laser oscillator 1 in the second embodiment reside in that the selective reflection member 40 as used in the foregoing embodiment is omitted and that a selective reflection coating for reflecting the output laser beam Lout and for allowing the pumping beams Lin to pass therethrough is given on a semispherical protruding portion 50p formed on the incident surface Min of a light duct 50 to reflect the output laser beam Lout.

Hereunder, description is made regarding the differences from the first embodiment.

The incident surface Min of the light duct 50 has formed thereon the semispherical protruding portion 50p of a radius (R) having its center on the center of the emission surface Mout (i.e., the end surface of the core member 12). Then, the selective reflection coating for reflecting the output laser beam Lout and for allowing the pumping beams Lin to pass therethrough is given on the surface of the semispherical protruding portion 50p. Further, the emission surface Mout of the light duct 50 is joined to one end surface of the laser oscillation optical fiber 10.

Thus, the output laser beam Lout emitted from the end surface on the light duct 50 side of the core member 12 in the laser oscillation optical fiber 10 travels within the right duct 50 in a direction from the emission surface Mout toward the incident surface Min to reach the semispherical protruding portion 50p formed on the incident surface Min and then, is reflected to travel in a direction completely opposite to the direction in which it traveled till then, whereby the output laser beam Lout is returned to the end surface of the core member 12 from which it was emitted.

Other respects of the second embodiment are the same as those in the first embodiment and therefore, description of such other respects is omitted for the sake of brevity.

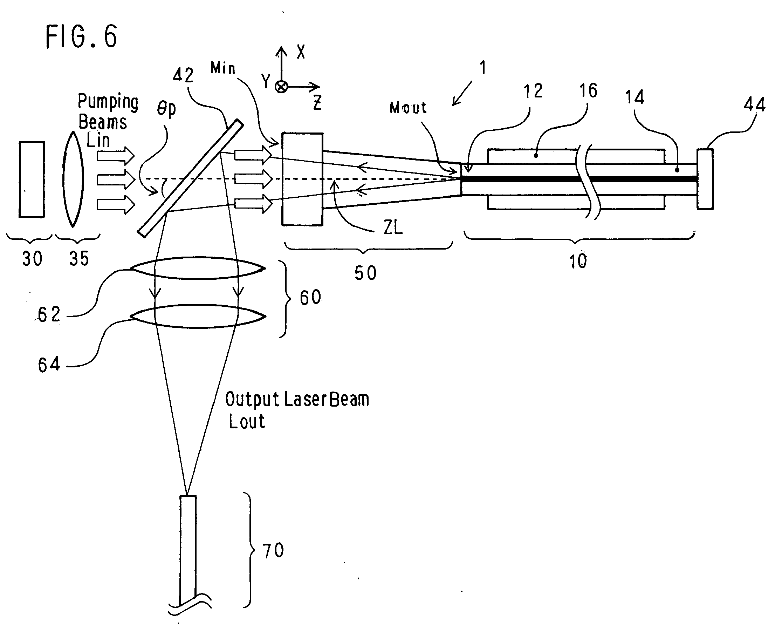

### (Third Embodiment: Figure 6)

Figure 6 is an exterior view showing the entire construction of a fiber laser oscillator 1 in the third embodiment, wherein a laser oscillation optical fiber 10 only is shown as a sectional view taken along a plane including a core member 12 therein.

Compared with that in the second embodiment, features of the fiber laser oscillator 1 in the third embodiment reside in the following respects. That is, a total reflection member 44 for reflecting the output laser beam Lout and the pumping beams Lin is provided at an end surface opposite to a light duct 50 of the laser oscillation optical fiber 10. The incident surface Min of the light duct 50 is flat not to reflect the output laser beam Lout. A selective reflection member 42 of an approximately flat plate shape (for reflecting the output laser beam Lout and for allowing the pumping beams Lin to pass therethrough) is provided at a predetermined angle (θp) between the light duct 50 and a pumping light source 30, so that the output laser beam Lout can be taken out by the selective reflection member 42.

Hereunder, description is made regarding the differences from the second embodiment.

The light duct 50 in the third embodiment is the same as the light duct 50 described in the foregoing first embodiment.

The total reflection member 44 (a total reflection mirror or the like) for reflecting the output laser beam Lout and the pumping beams Lin is joined to an end surface opposite to the light duct 50 of the laser oscillation optical fiber 10. Therefore, since the pumping beams Lin incident on the other end surface on the light duct 50 side of the laser oscillation optical fiber 10 can travel to reciprocate within the laser oscillation optical fiber 10 in the lengthwise direction of the same, the length of the laser oscillation optical fiber 10 in the third embodiment can be made to be about half the length of the laser oscillation optical fiber 10 in the first and second embodiments.

The output laser beam Lout emitted from the end surface on the light duct 50 side of the laser oscillation optical fiber 10 travel to pass through the light duct 50 and is emitted from the incident surface Min to reach the selective reflection member 42.

The selective reflection member 42 takes the shape of an approximately flat plate and is placed at the predetermined angle (θp) relative to the traveling direction of the pumping beams Lin between the pumping light source 30 and the light duct 50 (i.e., between the pumping beam condensing means 35 and the light duct 50). Further, the selective reflection member 42 is constituted by, e.g., a dichroic mirror which is capable of reflecting the output laser beam Lout and allowing the pumping beams Lin to pass therethrough.

With this configuration, the output laser beam Lout reaching the selective reflection member 42 is reflected by the selective reflection member 42 to travel in a direction depending on the predetermined angle (θp).

Then, at the traveling end of the output laser beam Lout reflected by the selective reflection member 42, the output laser beam Lout is condensed by an output laser beam condensing means 60 and is made incident on one end surface of a conveyance optical fiber 70 to be taken therefrom, in the same manner as those in the first and second embodiments.

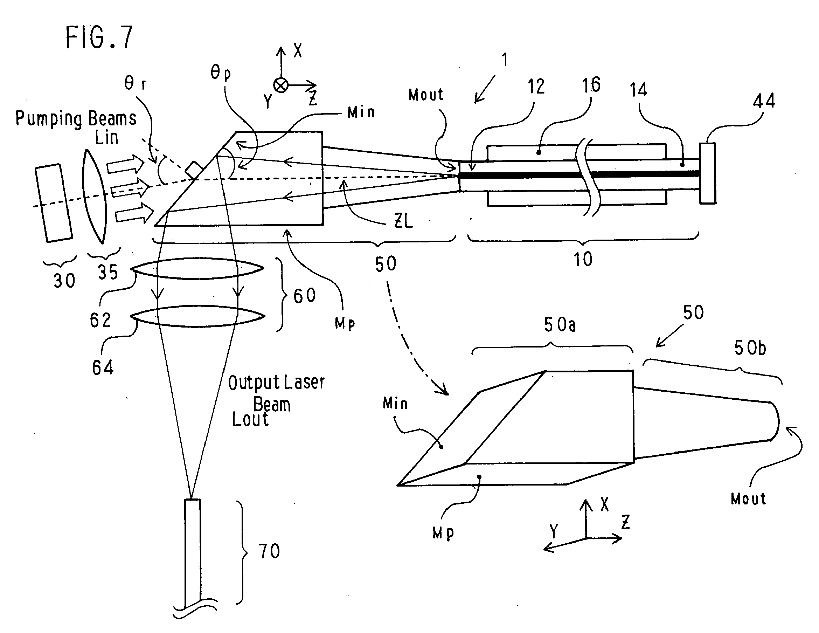

### (Fourth Embodiment: Figure 7)

Figure 7 is an exterior view showing the entire construction of a fiber laser oscillator 1 in the fourth embodiment, wherein a laser oscillation optical fiber 10 only is shown as a sectional view taken along a plane including a core member 12 therein.

Compared with that in the third embodiment, features of the fiber laser oscillator 1 in the fourth embodiment reside in the following respects. That is, the selective reflection member 42 as used in the third embodiment is omitted, and instead, the incident surface Min of a light duct 50 is formed to be inclined at a predetermined angle (θp) (which is the same angle (θp) as taken by the selective reflection member 42 in the third embodiment) and is given a selective reflection coating for reflecting the output laser beam Lout and for allowing the pumping beams Lin to pass therethrough. Further, the angle at which the pumping beams Lin are incident on the incident surface Min is altered in dependence on the angle of the incident surface Min as well as on the refractive index of the light duct 50.

Hereunder, description is made regarding the differences from the third embodiment.

The incident surface Min at the incident neighborhood section 50a of the light duct 50 is formed to take a flat shape inclined at the predetermined angle (θp) with respect to the traveling direction in which the pumping beams Lin incident thereon travel. Further, an output laser emission surface Mp from which the output laser beam Lout is emitted is formed to take a flat shape. While each of the aforementioned incident surface Min and the output laser emission surface Mp is a flat shape, other surfaces of the incident neighborhood section 50a are not required to be flat.

Of the output laser beams Lout generated within the core member 12, one which travels in the direction opposite to the light duct 50 is reflected by a total reflection member 44 (the pumping beams Lin are also reflected by the total reflection member 44). Then, the output laser beam Lout is emitted from the end surface on the light duct 50 side of the core member 12 into the light duct 50. The output laser beam Lout emitted into the light duct 50 propagate within the light duct 50 to reach the incident surface Min and is reflected at the incident surface Min in a direction depending on the predetermined angle (θp) thereby to be taken from the output laser emission surface Mp outside the light duct 50.

Then, at the traveling end of the output laser beam Lout reflected by the incident surface Min, the output laser beam Lout is condensed by an output laser beam condensing means 60 and is made incident on one end surface of a conveyance optical fiber 70 to be taken therefrom, in the same manner as that in the third embodiment.

In this particular embodiment, the incident angle of the pumping beams Lin on the incident surface Min is set to be inclined relative to the optical axis ZL of the light duct 50. That is, the incident angle (θr) of the pumping beams Lin on the incident surface Min is set in dependence on the angle (θp) of the incident surface Min and the refractive index of the light duct 50 so that the pumping beams Lin made incident to the light duct 50 travel along the optical axis ZL.

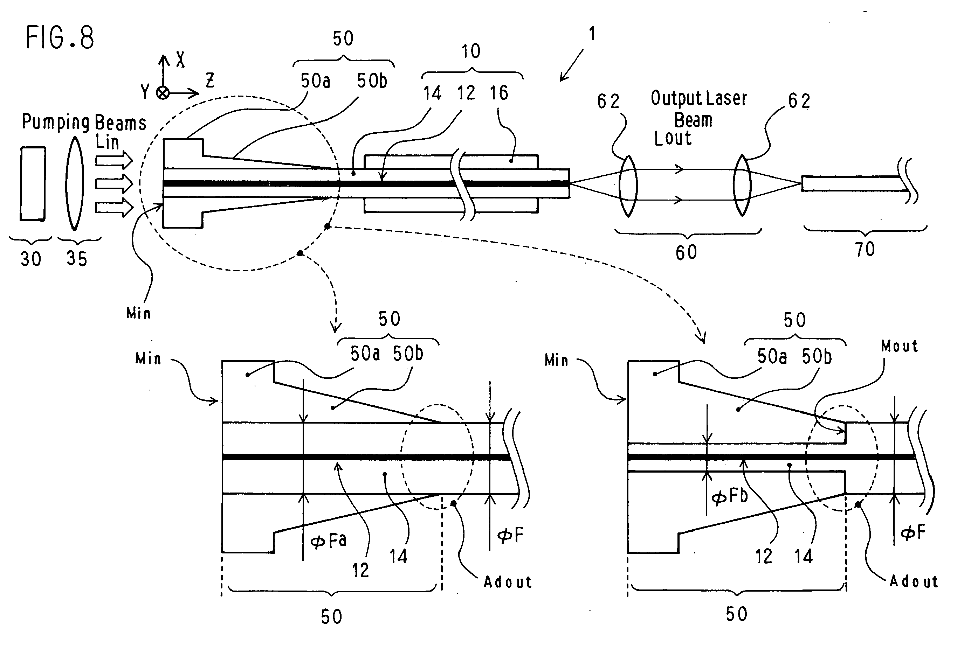

### (Fifth Embodiment: Figure 8)

Figure 8 is an exterior view showing the entire construction of a fiber laser oscillator 1 in the fifth embodiment, wherein a laser oscillation optical fiber 10 only is shown as a sectional view taken along a plane including a core member 12 therein.

Compared with that in the second embodiment, features of the fiber laser oscillator 1 in the fifth embodiment reside in the following respects. That is, in order that the output laser beam Lout emitted from an end surface on a light duct 50 side of the core member 12 is reflected in a direction opposite to the light duct 50, the core member 12 is extended to bring its end surface into alignment with the incident surface Min of the light duct 50, instead of providing the semispherical shape on the incident surface Min as described in the foregoing second embodiment. Further, the end surface of the core member 12 in alignment with the incident surface Min is given a selective reflection coating for reflecting the output laser beam Lout and for allowing the pumping beams Lin to pass therethrough.

Hereunder, description is made regarding the differences from the second embodiment.

First of all, at least the core member 12 is provided with an extension portion which is extended from the end surface on the light duct 50 side of the laser oscillation optical fiber 10 in the lengthwise direction thereof.

In the light duct 50, the extension portion of the core member 12 is arranged (embedded) so that it extends from the incident surface Min in the traveling direction of the pumping beams Lin. In this case, the light duct 50 may have arranged (embedded) therein the extension portion of the core member 12 which portion has its external surface covered with a clad member 14. In this particular embodiment, the extension portion of the core member 12 covered with the clad member 14 is arranged in the light duct 50. In this case, two method of forming the light duct 50 are practiced in dependence on the diameter ΦFa (ΦFb) of the clad member 14 which is arranged in the light duct 50 to surround the extension portion of the core member 12.

Where the diameter ΦFa of the clad member 14 arranged in the light duct 50 is set to be almost the same as the diameter ΦF of the clad member 14 of the laser oscillation optical fiber 10 which is on the forward side to which the pumping beams Lin travel from the light duct 50, any emission surface normal to the traveling direction of the pumping beams Lin is not formed at an emission end portion Adout of an emission neighborhood section 50b of the light duct 50, as shown at the lower-left in Figure 8. In this instance, while it is necessary to make the thickness of the light duct 50 thinner gradually to closely fit on the external surface of the laser oscillation optical fiber 10, it is unnecessary to machine the clad member 14 of the laser oscillation optical fiber 10 to a diameter ΦFb which is shown at the lower-right in Figure 8.

On the other hand, in another instance shown at the lower-right in Figure 8, the diameter ΦFb of the clad member 14 arranged in the light duct 50 is formed to be smaller than the diameter ΦF of the laser oscillation optical fiber 10 which is on the forward side to which the pumping beams Lin travel from the light duct 50. Therefore, it is possible to form an emission surface Mout normal to the traveling direction of the pumping beams Lin, at the emission end portion Adout of the emission neighborhood section 50b of the light duct 50. With this configuration, while the thickness of the light duct 50 at the emission end portion Adout in the instance shown at the lower-left in Figure 8 is made as gradually close to zero as possible, it is unnecessary to make the thickness of the light duct 50 at the emission end portion Adout in the instance shown at the lower-right in Figure 8 as gradually close to zero as possible, so that the formation of the light duct 50 is relatively easy in the latter instance.

Further, the extension portion of the core member 12 and the clad member 14 surrounding the extension portion which are arranged (embedded) in the light duct 50 are arranged (embedded) to place their end surfaces in alignment with the incident surface Min of the light duct 50.

Then, the selective reflection coating for reflecting the output laser beam Lout and for allowing the pumping beams Lin to pass therethrough is given on at least the end surfaces made in alignment with the incident surface Min (i.e., the end surface of the core member 12 or the clad member 14 on the light duct 50 side). The selective reflection coating may be given at the entire area of the incident surface Min.

With this construction, the output laser beam Lout is reflected by the end surface (the end surface in alignment with the incident surface Min) of the core member 12 on the light duct 50 side of the laser oscillation optical fiber 10, and therefore, the output laser beam Lout can be taken out of the end surface opposite to the light duct 50 of the laser oscillation optical fiber 10.

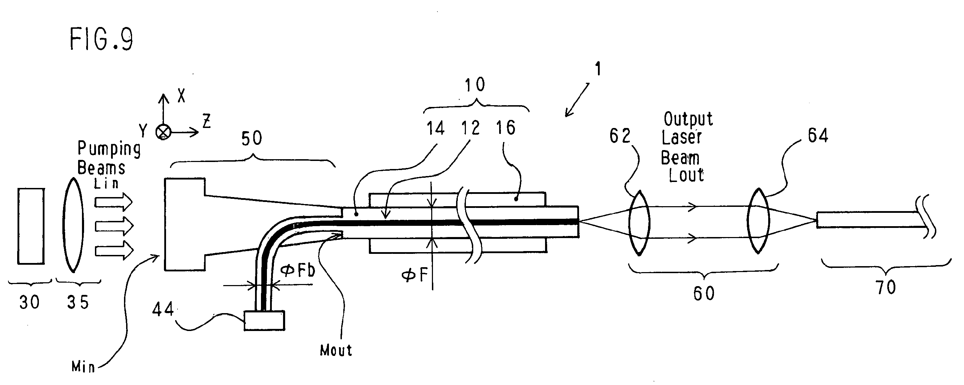

### (Sixth Embodiment: Figure 9)

Figure 9 is an exterior view showing the entire construction of a fiber laser oscillator 1 in the sixth embodiment, wherein a laser oscillation optical fiber 10 only is shown as a sectional view taken along a plane including a core member 12 therein.

Compared with that in the fifth embodiment, features of the fiber laser oscillator 1 in the sixth embodiment reside in the following respects. That is, instead of being provided in the direction toward the incident surface Min of a light duct 50, an extension portion on the light duct 50 side of the core member 12 (the extension portion and a clad member 14 surrounding the same) is provided to extend from a lateral surface of the light duct 50 outside of the same. Further, the end surfaces of the extension portion and the surrounding clad member 14 extending outside have joined thereto a total refection member 44 for reflecting the output laser beam Lout.

Hereunder, description is made regarding the differences from the fifth embodiment.

The extension portion of the core member 12 is arranged (embedded) in the light duct 50 to extend from the emission surface Mout toward the lateral surface of the light duct 50. The extension portion arranged (embedded) in the light duct 50 may be that whose external surface is covered with the clad member 14. In this particular embodiment, the extension portion is that covered with the clad member 14. In this case, like the fifth embodiment, two method of forming the light duct 50 are practiced in dependence on the diameter ΦFa (ΦFb) of the clad member 14 which is arranged in the light duct 50 to surround the extension portion of the core member 12. Figure 9 shows an instance of the diameter ΦFb < the diameter ΦF. Description regarding another instance of the diameter ΦFb = the diameter ΦF will be omitted since another such instance is the same as that described in the foregoing fifth embodiment.

The extension portion of the core member 12 and the surrounding clad member 14 which are provided to extend on the light duct 50 side in the lengthwise direction are embedded in the light duct 50 to extend from the emission surface Mout toward the lateral surface of the light duct 50 and are drawn outside from the lateral surface. The total reflection member 44 (a total reflection mirror or the like) for reflecting the output laser beam Lout is joined to the end surfaces at the extreme ends of the extension portion of the core member 12 and the surrounding clad member 14 which are drawn out from the lateral surface of the light duct 50.

It is preferable that the diameter ΦFb of the clad member 14 surrounding the extension portion of the core member 12 drawn out from the lateral surface of the light duct 50 be sufficiently small to suppress the pumping beams Lin leaking therefrom.

With this construction, the output laser beam Lout is reflected by the end surface on the light duct 50 side of the core member 12 of the laser oscillation optical fiber 10 (i,e., by the end surface of the core member 12 drawn out from the light duct 50), and therefore, the output laser beam Lout can be take out from the end surface opposite to the light duct 50 of the core member 12.

### (Other Modifications or Variations)

The fiber laser oscillator 1 according to the present invention is not limited to the external view, construction and the like shown and described in the foregoing embodiments, and various alterations, additions and omissions to and from the fiber laser oscillator 1 are possible without departing from the gist of the present invention.

For example, numerical data used in the description of the foregoing embodiments are for explanation purpose, and the present invention is not limited to these numerical data.

In particular, the shape of the light duct 50 (e.g., the ratio in area between the incident surface Min and the emission surface Mout and so on) may be determined by various methods without being determined in dependence on the simulation or the like described in the foregoing embodiments.

The output laser beam Lout from the fiber laser oscillator 1 according to the present invention can be utilized in various apparatuses using laser beams such as laser machining apparatus or the like.

Obviously, further modifications and variations of the present invention are possible in light of the above teachings. It is therefore to be understood that within the scope of the appended claims, the present invention may be practiced otherwise than as specifically described herein.

A fiber laser oscillator 1 is provided with a pumping light source 30 for emitting pumping beams Lin; beam condensing means (light duct) 50 for condensing the pumping beams Lin emitted from the pumping light source 30; and a laser oscillation optical fiber 10 for receiving the pumping beams Lin condensed by the beam condensing means 50 to generate an output laser beam Lout. The beam condensing means 50 has an incident surface Min for making the pumping beams Lin from the pumping light source 30 incident thereon and an emission surface Mout for emitting the pumping beams Lin therefrom. The emission surface Mout is made smaller in area than the incident surface Min. Further, the area of the emission surface Mout is made to be the same as or smaller than that of one end surface of the laser oscillation optical fiber 10.

## Claims

1. A fiber laser oscillator comprising:
a pumping light source for emitting a pumping beam;
beam condensing means for condensing the pumping beam emitted from the pumping light source; and
a laser oscillation optical fiber for receiving the pumping beam condensed by the beam condensing means to generate an output laser beam;
wherein the beam condensing means has an incident surface for making the pumping beam from the pumping light source incident thereon and an emission surface for emitting the pumping beam therefrom, the emission surface being made smaller in area than the incident surface; and
wherein the area of the emission surface is formed to be the same as or smaller than one end surface of the laser oscillation optical fiber.

2. A fiber laser oscillator comprising:
a laser oscillation optical fiber formed to be a rod-like shape and composed a rod-like core member extending in a lengthwise direction and a clad member smaller in refractive index than the core member and covering the external surface of the core member, the core member including a laser activating substance;
a pumping light source provided with a plurality of beam emission parts for emitting pumping beams;
a light duct having an incident surface for making the pumping beams from the plurality of beam emission parts incident thereon and an emission surface smaller in area than the incident surface and capable of condensing the pumping beams incident from the incident surface onto the emission surface;
wherein the emission surface of the light duct is made to be the same shape as or smaller than one end surface of the laser oscillation optical fiber and is joined to said one end surface;
wherein the shape of the light duct is determined by adjusting the dimensions of the incident and emission surfaces of the light duct and the distance between the incident and emission surfaces of the light duct so that when the pumping beams incident on the incident surface of the light duct and reaching the emission surface of the light duct are made incident on said one end surface of the laser oscillation optical fiber joined to the emission surface of the light duct, the incident angle of the pumping beams on said one end surface becomes less than or equal to an NA value representing the numerical aperture of the laser oscillation optical fiber; and
wherein the pumping light source is placed on the incident surface side of the light duct so that the pumping beams incident from the pumping light source are incident on the incident surface and so that the light duct condenses the incident pumping beams and makes the condensed pumping beams from the emission surface incident on said one end surface of the laser oscillation optical fiber.

3. The fiber laser oscillator as set forth in Claim 2, further comprising:
a selective reflection member taking a rod-like shape of the same diameter as the laser oscillation optical fiber and provided between the emission surface of the light duct and said one end surface of the laser oscillation optical fiber for reflecting an output laser beam generated within the core member and for allowing the pumping beams to pass therethrough;
wherein the output laser beam is emitted from the other end surface opposite to the light duct of the laser oscillation optical fiber to be taken out from the same.

4. The fiber laser oscillator as set forth in Claim 2, wherein:
the incident surface of the light duct is formed to be a semispherical shape which has its center on the center of the emission surface of the light duct;
the semispherical incident surface is given a selective reflection coating for reflecting the output laser beam generated within the core member and for allowing the pumping beams to pass therethrough; and
the output laser beam is emitted from the other end surface opposite to the light duct of the laser oscillation optical fiber to be taken out from the same.

5. The fiber laser oscillator as set forth in Claim 2, further comprising:
a total reflection member joined to the other end surface opposite to the light duct of the laser oscillation optical fiber for reflecting the output laser beam generated within the core member and the pumping beams passing through the clad member; and
a selective reflection member taking an approximately flat plate shape and provided between the pumping light source and the light duct to be inclined at a predetermined angle relative to the traveling direction of the pumping beams for reflecting the output laser beam generated within the core member and for allowing the pumping beams to pass therethrough;
wherein the output laser beam emitted from the end surface on the light duct side of the laser oscillation optical fiber is reflected by the selective reflection member placed at the predetermined angle, to be taken out from the laser oscillation optical fiber .

6. The fiber laser oscillator as set forth in Claim 2, further comprising:
a total reflection member joined to the other end surface opposite to the light duct of the laser oscillation optical fiber for reflecting the output laser beam generated within the core member and the pumping beams passing through the clad member;
wherein the incident surface of the light duct is formed to take a flat surface extending at a predetermined angle relative to the traveling direction of the incident pumping beams and is given a selective reflection coating for reflecting the output laser beam generated within the core member and for allowing the pumping beams to pass therethrough; and
wherein the output laser beam emitted from the end surface on the light duct side of the laser oscillation optical fiber is reflected by the incident surface extending at the predetermined angle of the light duct, to be taken out from the laser oscillation optical fiber.

7. The fiber laser oscillator as set forth in Claim 2, further comprising:
an extension portion of the core member provided by extending at least the core member from the end surface on the light duct side of the laser oscillation optical fiber in the lengthwise direction and arranged in the light duct to extend from the emission surface toward the incident surface of the light duct, an end surface of the extension portion of the core member being in alignment with the incident surface of the light duct;
wherein a selective reflection coating is given on the end surface of at least the extension portion of the core member for reflecting the output laser beam generated within the core member and for allowing the pumping beams to passing therethrough; and
wherein the output laser beam is emitted from the end surface opposite to the light duct of the laser oscillation optical fiber to be taken out from the same.

8. The fiber laser oscillator as set forth in Claim 2, further comprising:
an extension portion of the core member provided by extending at least the core member from an end surface on the light duct side of the laser oscillation optical fiber in the lengthwise direction and arranged in the light duct to extend from the emission surface toward a lateral surface of the light duct to be taken outside the light duct; and
a total reflection member joined to an end surface of the extension portion of the core member taken outside the light duct from the lateral surface of the same for reflecting the output laser beam generated within the core member;
wherein the output laser beam is emitted from the other end surface opposite to the light duct of the laser oscillation optical fiber to be taken out from the same.
